(19) **Europäisches Patentamt**

**European Patent Office**

**Office européen des brevets**

(11) **EP 1 387 452 B1**

(12) **EUROPEAN PATENT SPECIFICATION**

(45) Date of publication and mention
of the grant of the patent:
**06.09.2006 Bulletin 2006/36**

(51) Int Cl.:
**H01S 5/183** (2006.01)

(21) Application number: **02255323.4**

(22) Date of filing: **30.07.2002**

(54) **Optical device**

Optisches Gerät

Appareil optique

(84) Designated Contracting States:
**DE FR GB**

(43) Date of publication of application:
**04.02.2004 Bulletin 2004/06**

(73) Proprietor: **Hitachi, Ltd.**
**Chiyoda-ku,**
**Tokyo 101-8010 (JP)**

(72) Inventor: **Tanaka, Toshiaki**
**Girton,**
**Cambridge CB3 0NW (GB)**

(74) Representative: **Piotrowicz, Pawel Jan Andrzej et al**
**Venner Shipley LLP**
**20 Little Britain**
**London EC1A 7DH (GB)**

(56) References cited:
**EP-A- 0 898 344**    **EP-A- 1 128 203**
**US-A- 5 493 577**    **US-A- 6 026 108**

• **HAYASHI Y ET AL: "LASING CHARACTERISTICS OF LOW-THRESHOLD OXIDE CONFINEMENT INGAAS- GAALAS VERTICAL-CAVITY SURFACE-EMITTING LASERS" IEEE PHOTONICS TECHNOLOGY LETTERS, IEEE INC. NEW YORK, US, vol. 7, no. 11, 1 November 1995 (1995-11-01), pages 1234-1236, XP000537943 ISSN: 1041-1135**

EP 1 387 452 B1

**Description**

The present invention relates to an optical device particularly, but not exclusively, to a vertical-cavity surface-emitting laser or an optical amplifier or modulator comprising a vertical-cavity surface-emitting laser structure.

Optical devices may be fabricated using semiconductor materials and can be used as optical components in optical fibre communications applications. These devices include laser diodes and optical amplifiers.

One such optical device is a vertical-cavity surface-emitting laser (VCSEL). A VCSEL comprises a stacked structure including an active region, for example comprising one or more quantum wells, disposed within a cavity having distributed Bragg reflectors at each end. Examples of VCSELs are described in US-A-5068868, US-A-5089860 and US-A-5206871.

VCSELs are of particular interest in optical fibre communications applications since they offer a number of advantages compared with other types of semiconductor laser. VCSELs produce circularly-shaped light beams which can be coupled to circular optical fibres with high efficiency. They also benefit from having high modulation bandwith and low power consumption. Furthermore, they can be easily fabricated in arrays.

Despite these advantages, VCSELs suffer the drawback that they emit radiation comprising high-order transverse modes. Single zero-order or fundamental mode emission is difficult to achieve.

One solution is to introduce an aluminium oxide ($Al_xO_y$) "stop" between the distributed Bragg reflector and the active region. This is achieved by partially oxidizing an aluminium arsenide (AlAs) layer and is described in "Native-oxide defined ring contact for low threshold vertical-cavity lasers", D. L. Huffaker *et al.,* Applied Physics Letters, volume 65, pp. 97-99 (1994). The $Al_xO_y$ "stop" defines an aperture which provides charge carrier confinement and reduces current spreading. The aperture also provides optical confinement by index-guiding the optical wave.

US-A-6026108 describes a VCSEL and an integrated intra-cavity quantum well photo-detector comprising a GaAs substrate, an overlying n-doped distributed Bragg reflector mirror stack, an overlying active gain region including a one-wavelength spacer and a quantum well stack, an overlying p-doped distributed Bragg reflector mirror stack and an overlying intra-cavity quantum well photo-detector. One or more $Al_xO_y$ current confinement layers are formed in the p-doped mirror stack.

However, the use of a confining $Al_xO_y$ layer has disadvantages. It introduces a large discontinuity in refractive index at the interface between $Al_xO_y$ and AlAs. The discontinuity causes the fundamental mode to become unstable and induces higher-order transverse modes. This is because the optical field functions of the fundamental and higher-order modes mix and so redistribute the optical field with a deformed function. In other words, the fundamental and higher-order transverse modes become coupled.

Furthermore, if a VCSEL, including an $Al_xO_y$ layer, is employed as an optical modulator and is fed ultrashort pulses, for example having a duration of the order of a few, tens or hundreds of femtoseconds (fs), then its response exhibits multimode beating.

Attempts have been made to reduce the size of the discontinuity in refractive index associated with the $Al_xO_y$ layer or lessen its effect.

One solution has been to reduce the thickness of the $Al_xO_y$ layer and a device employing this solution is described in "High-Power Single-Mode Selectively Oxidized Vertical-Cavity Surface-Emitting Lasers", B. Weigl *et al.*, IEEE Photonics Technology Letters, volume 8, pp. 971-973 (1996).

Another solution is shift the $Al_xO_y$ layer towards a node in a longitudinal standing wave pattern. This reduces the overlap of the $Al_xO_y$ layer and the electric field intensity. Reference is made to "Efficient Single-Mode Oxide-Confined GaAs VCSELs Emmitting in the 850-nm Wavelength Regime", M. Grabherr *et al.*, IEEE Photonics Technology Letters, vol 9, pp. 1304-1306 (1997).

It is known to include a plurality of $Al_xO_y$ confining layers. However, the reason for doing so is to reduce threshold current and a device including a plurality of $Al_xO_y$ confining layers is described in "Record low-threshold index-guided InGaAa GaAlAs vertical-cavity surface-emitting laser with native oxide confinement", Y. Hayashi *et al.*, Electron Letters, volume 31, pp 560-562 (1995) and in "Lasing Characteristics of Low-Threshold Oxide Confinement InGaAs-GaAlAs Vertical-Cavity Surface-Emitting Lasers" Y. Hayashi *et al.*, IEEE Photonics Technology Letters, volume 7, pp. 1233-1236 (1995). However, this has several disadvantages. The use of a plurality of $Al_xO_y$ confining layers not only increases the effective refractive index step (which accentuates the problems described earlier), but also introduces strain between the semiconducting layers and the $Al_xO_y$ confining layers due to differences in lattice constant and thermal expansion coefficient. The strain may induce crystal dislocations or even cause mechanical failure. Another problem is that the $Al_xO_y$ confining layers suffer from non-uniformity.

The present invention seeks to provide an improved optical device and in particular to help ameliorate detrimental effects of introducing confining layers.

According to the present invention there is provided an optical device including a lower mirror layer comprising a first distributed Bragg reflector comprising a plurality of alternating layers of relatively high and relatively low refractive index material and a columnar waveguide structure upstanding from the lower mirror layer, the structure comprising a lower confinement layer formed on the lower mirror, an active region formed on the lower confinement layer and which comprises one or more quantum wells arranged to emit electromagnetic radiation at a given wavelength $\lambda$, an upper confinement layer formed on the active region and an upper mirror formed on the upper confinement layer and which comprises a second distributed Bragg reflector composing a plurality of alternating layers of relatively high and relatively low refractive index material and which further comprises between three and seven annular confining layers, wherein the upper mirror comprises first, second and third regions, the first region formed on the upper confinement layer and which comprises a plurality of alternating layers of relatively high and relatively low refractive index material, the second region formed on the first region and which comprises a plurality of alternating layers of relatively high and relatively low refractive index material, and which comprises the annular confining layers, the confining layers arranged to be co-planar with layers of one material in the plurality of alternating layers, such that each confining layer forms a respective aperture in a corresponding layer having a diameter of between 1 and 6 $\mu$m, the aperture being filled with the material and the confining layers having a refractive index lower than the layers and the confining layers having a thickness t substantially equal to the thickness of the corresponding layer, the thickness t being substantially equal to $\lambda/4n$, where n is a value of refractive index of the material in the corresponding layer, and the third region formed on the second regions and which comprises a plurality of alternating layers of relatively high and relatively low refractive index material, wherein the confining layers are for stabilizing and guiding a fundamental transverse mode wave through a core region of the mirror.

The confining layers help to increase a difference in transmissivity between regions of the mirror having and not having confining layers. When optically pumped, electromagnetic radiation more easily penetrates regions of the mirror without confining layers and so promotes selective excitation within the active region. This helps generate a stable fundamental mode. The advantage of limiting the number of confining layers is to reduce strain between the confining and alternating layers.

The second region may comprise five confining layers. The confining layers may comprise aluminium oxide. The first region may comprise between two and eight pairs of layers or between three and seven pairs of layers comprising relatively high and relatively low refractive index material. The first region may comprise alternating layers of $Al_{0.9}Ga_{0.1}As$ and $Al_{0.1}Ga_{0.9}As$. The second region may comprise alternating layers of AlAs and $Al_{0.1}Ga_{0.9}As$.

The confining means may be configured to limit transverse modes of electromagnetic radiation propagating through the mirror. The confining region may be configured to allow propagation of a fundamental transverse mode through the mirror. The device may be a vertical-cavity surface-emitting laser (VCSEL) and may be configured to be electrically or optically pumped.

Upper and lower mirrors may be arranged to form a cavity. The mirror may be disposed relatively close to a surface for emitting or receiving electromagnetic radiation and the other mirror may be disposed relatively far from the surface. The mirror may be disposed relatively far from a substrate and the other mirror may be disposed relatively close to the substrate. The cavity may have a length of an order of a wavelength of the electromagnetic radiation.

According to the present invention there is also provided apparatus including means for splitting a first pulse into second and third pulses, means for delaying the third pulse by a known period so as to produce a delayed third pulse, an optical device, means for feeding a fourth pulse into the device and means for feeding the first and delayed third pulses into the device.

According to the present invention there is also provided a method of fabricating an optical device comprising providing a lower mirror layer comprising a first distributed Bragg reflector comprising a plurality of alternating layers of relatively high and relatively low refractive index material, and providing a columnar waveguide structure upstanding from the lower mirror layer, the structure comprising: a lower confinement layer formed on the lower mirror, an active region formed on the lower confinement layer and which comprises one or more quantum wells arranged to emit electromagnetic radiation at a given wavelength $\lambda$, providing an upper confinement layer on the active region and providing an upper mirror formed on the upper confinement layer and which comprises a second distributed Bragg reflector comprising a plurality of alternating layers of relatively high and relatively low refractive index material and between three and seven annular confining layers, wherein providing the upper mirror comprises providing first, second and third regions, the first regions formed on the upper confinement layer and which comprises a plurality of alternating layers of relatively high and relatively low refractive index material, the second region formed on the first region and which comprises a plurality of alternating layers of relatively high and relatively low refractive index material, and which further comprises between three and seven annular confining layers arranged to be co-planar with layers of one material in the plurality of alternating layers, such that each confiding layer forms a respective apertures in a corresponding layer having a diameter of between 1 and 6 $\mu$m, the aperture being filled with the material and the confining layers having a refractive index lower than the layers, and the confining layers having a thickness t substantially equal to the thickness of the corresponding layer, the thickness t being substantially equal to $\lambda/4n$, where n is a value of refractive index of the material in the corresponding layer, and the third region formed on the second regions and which comprises a plurality of alternating layers of relatively high and relatively low refractive index material, wherein the confining layers are for stabilizing and guiding a fundamental transverse mode wave through a core region of the mirror.

Embodiments of the present invention will now be described, by way of example, with reference to the accompanying drawings in which:

Figure 1 is a cross-section of a prior art VCSEL without an aluminium oxide layer;
Figure 2 is a cross-section of a prior art VCSEL including a single aluminium oxide layer;
Figure 3 is a cross-section of a VCSEL according to the present invention;
Figure 4 is a plan view of the VCSEL shown in Figure 3;
Figures 5a, 5b and 5c show zero-, first- and second-order transverse waves respectively;
Figure 6 shows a relationship between aperture width for confining a transverse mode and number of confining layers for zero-, first- and second-order transverse modes;
Figure 7 shows a relationship between aperture width for confining a transverse mode and thickness of a single confining layer for zero-, first- and second-older transverse modes;
Figure 8 shows a relationship between aperture width for confining a transverse mode and thickness of five confining layers for zero-, first- and second-order transverse modes;
Figure 9 shows, for a single confining layer, a relationship between aperture width for confining a transverse mode and a number of pairs of layers within a spacer for zero- and first-order transverse modes;
Figure 10 shows, for five confining layers, a relationship between aperture width for confining a transverse mode and a number of pairs of mirror layers within a spacer for zero- and first-order transverse modes;
Figure 11 shows, for a spacer comprising five pairs of mirror layers, calculated reflectance spectra for zero, one and five confining layers;
Figure 12 shows, for a spacer comprising five pairs of mirror layers, calculated transmittance spectra for zero, one and five confining layers;
Figure 13 shows, for an optically pumped device which includes a spacer comprising five pairs of mirror layers, calculated transmission and reflectivity at 935 nm depending on a number of confining layers;
Figure 14 shows, for a spacer comprising five pairs of mirror layers, cavity resonance peaks of reflectance spectra for zero, one and five confining layers;
Figure 15 shows, for a spacer comprising five pairs of mirror layers, a relationship between resonant peak wavelength and a number of confining layers;
Figure 16 shows, for a spacer comprising five pairs of mirror layers, a relationship between full width at half maximum (FWHM) of a resonant peak and a number of confining layers;
Figure 17 shows, for a device emitting around 850 nm including a spacer comprising five pairs of mirror layers, calculated transmittance spectra for zero and five confining layers;
Figure 18 shows, for a device emitting around 850 nm including a spacer comprising five pairs of mirror layers, cavity resonance peaks of reflectance spectra for zero, one and five confining layers;
Figure 19 shows, for a device emitting around 1300 nm including a spacer comprising five pairs of mirror layers, calculated transmittance spectra for zero and five confining layers;
Figure 20 shows, for a device emitting around 1300 nm including a spacer comprising five pairs of mirror layers, cavity resonance peaks of reflectance spectra for zero, one and five confining layers;
Figure 21 shows a generic VCSEL used to determine a value of effective refractive index step;
Figure 22a shows a simplified cross-section of a prior art VCSEL including longitudinal wave amplitudes;
Figure 22b shows a simplified cross-section of a cross-section of a VCSEL according to the present invention including longitudinal wave amplitudes;
Figure 23a and 23b show effective refractive index steps for the devices shown in Figure 22a and 22b respectively;
Figure 24a shows a simplified cross-section of a prior art VCSEL including light incident on the device for optical pumping and excitation within an active region;
Figure 24b shows a simplified cross-section of a VCSEL according to the present invention including light incident on the device for optical pumping and excitation within an active region;
Figures 25a to 25d show a device at successive stages of fabrication;
Figure 26 shows a multimode VCSEL amplifier, a pair of input pulses and an output pulse;
Figure 27 shows a single mode VCSEL amplifier, a pair of input pulses and an output pulse and
Figure 28 is a schematic view of an integrated device comprising waveguides, a phase shifter and a VCSEL modulator.

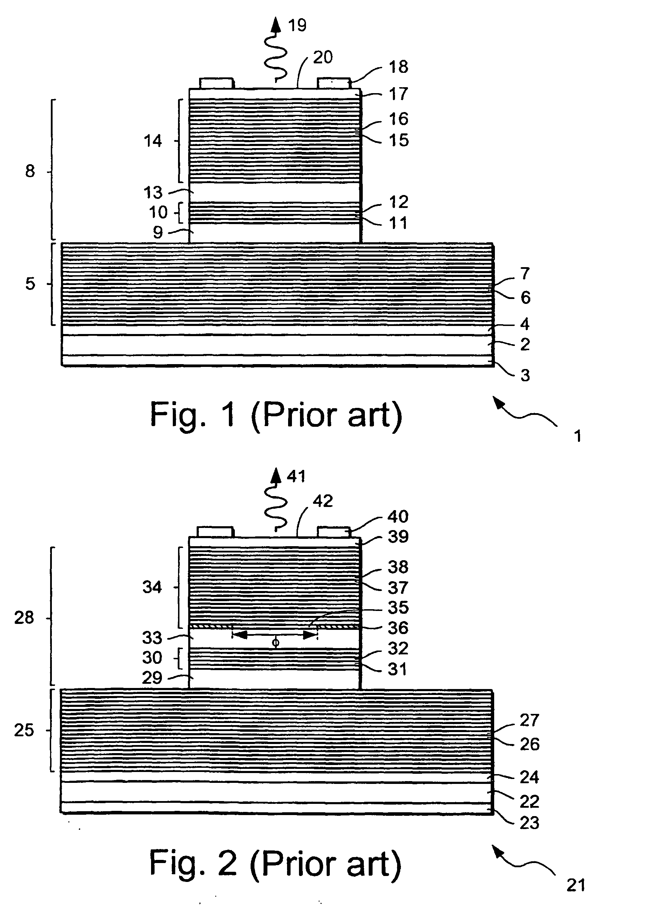

Referring to Figure 1, a first embodiment of a prior art vertical-cavity surface-emitting laser (VCSEL) 1 is shown in cross-section. The VCSEL 1 represents background art that is useful for understanding the invention.

The VCSEL 1 comprises a gallium arsenide (GaAs) substrate 2 having an underlying metal contact 3, an overlying buffer layer 4 and a mirror 5, hereinafter referred to as a lower mirror 5. The lower mirror 5 comprises a quarter-wave stack, commonly known as a distributed Bragg reflector, comprising a plurality of alternating layers 6, 7 of relatively high and relatively low refractive index material, such as gallium arsenide (GaAs) and aluminium gallium arsenide ($Al_xGa_{1-x}As$) respectively. An upstanding waveguide structure 8 is disposed on the lower mirror 5. The upstanding waveguide structure 8 includes a first confinement layer 9. An active region 10, comprising well and barrier layers 11, 12 for forming quantum wells, overlies the first confinement region 9. A second confinement layer 13 is formed on the active region 10. An upper mirror 14 comprises a second distributed Bragg reflector, comprising a plurality of alternating layers 15, 16 of relatively high and relatively low refractive index material, such as gallium arsenide (GaAs) and aluminium gallium arsenide ($Al_xGa_{1-x}As$) respectively. A contact layer 17 is provided with a top contact 18. The active and confinement regions 9, 10, 13 define a laser cavity. When a bias is applied across the top and bottom contacts 4, 18, radiation 19 is emitted from a top surface 20 of the waveguide structure 7.

Referring to Figure 2, a second embodiment of a prior art VCSEL 21 is shown in cross-section. The VCSEL 21 shown in Figure 2 represents background art, similar to the devices described in IEEE Photonics Technology Letters *ibid.,* and is useful for understanding the invention.

The VCSEL 21 comprises a substrate 22 having an underlying rear contact 23, an overlying buffer layer 24 and a lower mirror 25. The lower mirror 25 comprises a distributed Bragg reflector, comprising a plurality of alternating layers 26, 27 of relatively high and relatively low refractive index material, such as GaAs and $Al_xGa_{1-x}As$ respectively. An upstanding waveguide structure 28 is disposed on the lower mirror 25. The upstanding waveguide structure 28 includes a first confinement layer 29. An active region 30 comprising well and barrier layers 31, 32 for forming quantum wells, overlies the first confinement region 29. A second confinement layer 33 is formed on the active region 30. An upper mirror 34 comprises a second distributed Bragg reflector, comprising a first layer 35, a confining layer 36 for defining an aperture and a plurality of alternating layers 37, 38 of relatively high and relatively low refractive index material. The first layer 35 comprises AlAs, the confining layer 36 comprises aluminium oxide ($Al_xO_y$) and the alternating layers 37, 38 comprise GaAs and $Al_xGa_{1-x}As$. A contact layer 39 is disposed on the upper mirror 34 on which a top contact 40 is arranged. The active and confinement regions 29, 30, 33 define a laser cavity. When a bias is applied across the top and bottom contacts 23, 40 radiation 41 is emitted from a top surface 42 of the waveguide structure 28.

The VCSEL 21 suffers a number of disadvantages.

There is large discontinuity in refractive index at the interface between $Al_xO_y$ and AlAs layers 35, 36. This causes coupling of fundamental and higher-order transverse modes. Moreover, if ultrashort pulses, for example of duration 1fs to 1ps, are input into the VCSEL 21, then its response exhibits multimode beating. This will be described in more detail later. Another disadvantage is that for fundamental transverse mode emission, an aperture width, $\phi$, is used which is $3\mu m$ or less.

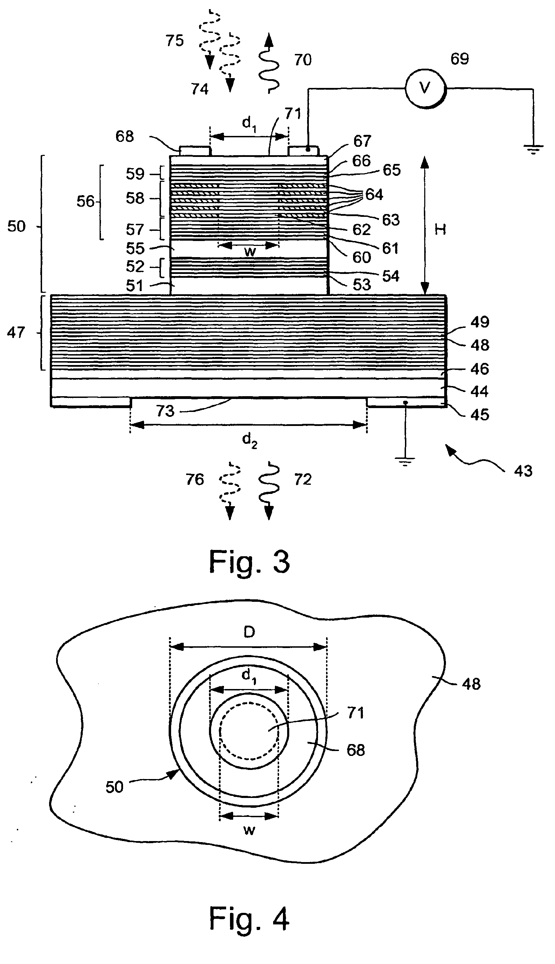

Referring to Figures 3 and 4, an embodiment of the present invention which may be used as a laser, an amplifier or a modulator is a vertical-cavity surface-emitting laser (VCSEL) 43 and is shown in cross-section.

The VCSEL 43 comprises a substrate 44 having an underlying metal contact 45, an overlying buffer laying 46 and an overlying mirror 47, hereinafter referred to as a lower mirror 47. In this example, the substrate 44 comprises (001)-orientated GaAs, doped with an n-type impurity, such as silicon (Si), to a concentration ($N_D$) $1 \times 10^{18}$ cm$^{-3}$ and the buffer layer 46 comprises GaAs, doped with an n-type impurity, such as Si, to a concentration ($N_D$) of $1 \times 10^{18}$ cm$^{-3}$. The buffer layer 46 has a thickness of $0.5\mu m$. The rear contact 45 comprises an annealed gold-germanium-nickel (AuGeNi) ohmic contact.

The lower mirror 47 comprises a quarter-wave stack, commonly known as a distributed Bragg reflector, comprising a plurality of alternating layers 48, 49 of relatively high and relatively low refractive index material, such as $Al_{0.1}Ga_{0.9}As$ and AlAs respectively. The thickness of each $Al_{0.1}Ga_{0.9}As$ layers 48 is 67 nm and the thickness of each AlAs layer 49 is 77 nm. Preferably, the layers 48, 49 are doped with an n-type impurity, such as Si, to a concentration ($N_D$) of $1 \times 10^{18}$ cm$^{-3}$. There may be between 10 and 40 pairs of layers 48, 49. In this example there are 25.5 pairs of layers 48, 49, the "half" layer comprising AlAs.

An upstanding waveguide structure 50 is disposed on the lower mirror 47. The waveguide 50 is substantially columnar and is substantially circular in plan view.

Preferably, the diameter, D, of the waveguide 50 is between 25 and 35 $\mu m$. In this example, the height, H, of the waveguide 50 is about 4.0 $\mu m$.

The upstanding waveguide structure 50 includes a lower confinement layer 51. In this example, the lower confinement layer 51 comprises $Al_{0.4}Ga_{0.6}As$, which is preferably doped with an n-type impurity, such as Si, to a concentration ($N_D$) of at least $8 \times 10^{17}$ cm$^{-3}$. The lower confinement layer 51 is 103 nm thick.

An active region 52 overlies the lower confinement region 51. The active region 52 comprises alternating layers 53, 54 for forming one or more quantum wells. In this example, the alternating layers 53, 54 comprise $Al_{0.1}Ga_{0.9}As$ and $In_{0.15}Ga_{0.85}As$ for forming barriers and quantum wells respectively. In this example, there are four layers of $Al_{0.1}Ga_{0.9}As$ 53 and three layers of $In_{0.15}Ga_{0.85}As$ 54, arranged to form three quantum wells. The $Al_{0.1}Ga_{0.9}As$ layers 53 are 10 nm thick and the $In_{0.15}Ga_{0.85}As$ layers 54 are 7 nm thick. The $Al_{0.1}Ga_{0.9}As$ and $In_{0.15}Ga_{0.85}As$ layers 53, 54 are undoped. The active region 52 may be arranged to emit at a wavelength $\lambda$ within a range of 780 to 1000 nm and this example $\lambda$ ~ 935 nm.

An upper confinement layer 55 is formed on the active region 52. In this example, the upper confinement layer 55 comprises $Al_{0.4}Ga_{0.6}As$, which is preferably doped with a p-type impurity, such as beryllium (Be), to a concentration

$(N_A)$ of at least $8 \times 10^{17}$ cm$^{-3}$. The upper confinement layer 55 is 103 nm thick.

An upper mirror 56 comprises a second distributed Bragg reflector. The second distributed Bragg reflector comprises first, second and third regions 57, 58, 59. Preferably, the upper mirror 56 has a reflectivity of over 0.99.

The first region 57 comprises a plurality of alternating layers 60, 61 of relatively low and relatively high refractive index material, such as $Al_xGa_{1-x}As$ and $Al_yGa_{1-y}As$ respectively, wherein x>y. In this example, the mole fraction of Al in $Al_xGa_{1-x}As$ and $Al_yGa_{1-y}As$ are 0.9 and 0.1 respectively. Each $Al_{0.9}Ga_{0.1}As$ layer 60 has a thickness of 76 nm and each $Al_{0.1}Ga_{0.9}As$ layer 61 has a thickness of 67 nm.

Preferably, the layers 60, 61 are doped with p-type impurity, such as beryllium (Be), to a concentration $(N_A)$ of at least $1 \times 10^{18}$ cm$^{-3}$. There is at least one pair of layers 60, 61. Preferably, there are between two and eight pairs of layers 60, 61. More preferably, there are between three and seven pairs of layers 60, 61.

The second region 58 comprises alternating layers 62, 63 of relatively low and relatively high refractive index material. The layers 62, 63 in the second region 58 may comprise the same material as layers 60, 61 in the first region 57. In this example, however, the layers 62, 63 comprise AlAs and $Al_{0.1}Ga_{0.9}As$ respectively. Each AlAs layers 62 has a thickness of 77 nm and each $Al_{0.1}Ga_{0.9}As$ layer 63 has a thickness of 67 nm. Preferably, the layers 62, 63 are doped with p-type impurity, such as beryllium (Be), to a concentration $(N_A)$ of at least $1 \times 10^{18}$ cm$^{-3}$. There is at least one pair of layers 62, 63. Preferably, there are between two and ten layers. More preferably, there are between three and seven pairs of layers 62, 63.

The second region 58 further comprises means for optically confining electromagnetic radiation, in the form of confining layers 64. In this example, the confining layers 64 comprise aluminium oxide $(Al_xO_y)$. However, the confining layers 64 may comprise a material having a refractive index lower than layers 62, 63. Preferably, the confining layers 64 have a high resistance to confine injection current.

The confining layers 64 are arranged to be co-planar with the one or more of the layers 62, 63. Preferably, the confining layers 64 are co-planar with a one type of alternating layer 62, 63, such as the AlAs layers 62. In this example, the confining layers 64 are co-planar with the AlAs layers 62 and surround them so as to form apertures having a width W, as indicated in Figures 3 and 4. Preferably, W is in the range of 1 to 6 $\mu$m. In this case, the apertures are substantially circular and the confining layers 64 are substantially annular in plan view. The confining layers 64 are arranged in a stacked or overlying configuration and are separated by intermediate layers, in this case comprising $Al_{0.1}Ga_{0.9}As$ 63. In this example, each confining layer 64 is substantially the same thickness and is 77 nm thick.

The third region 59 comprises a plurality of alternating layers 65, 66 of relatively low and relatively high refractive index material. The layers 65, 66 in the third region 59 may comprise the same materials as the layers 60, 61 in the first region 57. In this example, the layers 65, 66 comprise $Al_{0.9}Ga_{0.1}As$ and $Al_{0.1}Ga_{0.9}As$ respectively. Each $Al_{0.9}Ga_{0.1}As$ layers 65 has a thickness of 76 nm and each $Al_{0.1}Ga_{0.9}As$ layer 66 has a thickness of 67 nm. Preferably, the layers 65, 66 are doped with p-type impurity, such as beryllium (Be), to a concentration $(N_A)$ of at least $1 \times 10^{18}$ cm$^{-3}$. Preferably, there are between 1 and 20 layers 65, 66. In this example there are 15.5 pairs of layers 65, 66, the "half" layer comprising $Al_{0.9}Ga_{0.1}As$. The third region 59 may be omitted.

The thickness of each alternating layers 48, 49, 60, 61, 62, 63, 65, 66 may be determined using:

$$t = \frac{\lambda}{4n} \qquad\qquad\qquad (1)$$

where t is a thickness of a layer 48, 49, 60, 61, 62, 63, 65, 66, $\lambda$ is the wavelength of electromagnetic radiation emitted by the laser, which in this example is 935 nm, and n is the refractive index of the material of the layer 48, 49, 60, 61, 62, 63, 65, 66. Values of refractive index are given in Table 1 below:

Table 1

| Material | Refractive Index |
|---|---|
| GaAs | 3.542 |
| $Al_{0.1}Ga_{0.9}As$ | 3.475 |
| $Al_{0.4}Ga_{0.6}As$ | 3.308 |
| $Al_{0.9}Ga_{0.1}As$ | 3.074 |
| AlAs | 3.025 |

(continued)

| Material | Refractive Index |
|----------|------------------|
| $Al_2O_3$ | 1.70 |

For $Al_xO_y$, a higher value of refractive index is used than the refractive index for $Al_2O_3$. This is because $Al_xO_y$ may be non-stoichiometric and may also include As. This may arise due to the process by which $Al_xO_y$ is formed. Therefore, for $Al_xO_y$, a value of refractive index may be used within a range between 1.70 and 3.025 and which is preferably closer to 1.70 than 3.025.

Values of refractive index may be used which are dependent upon the wavelength of electromagnetic radiation.

A capping layer 67 is disposed on the upper mirror 56. The capping layer 67 comprises GaAs and is preferably doped with a p-type impurity, such as Be, to a concentration ($N_A$) of at least $5 \times 10^{18}$ cm$^{-3}$. The capping layer 67 has a thickness of 132 nm, which corresponds to half a wavelength ($\lambda/2n$).

A top contact 68 is arranged on the waveguide structure 50. In this example, the top contact 68 comprises TiPtAu and is annular to allow radiation to pass in and/or out of the waveguide structure 50. The top contact 68 may comprise a transparent material 62, such as indium tin oxide (ITO).

For the sake of clarity, a conformal insulator comprising silicon nitride ($Si_3N_4$) or silicon dioxide ($SiO_2$), used to connect the top contact 68 to bond pads is not shown.

The waveguide guide structure 50 may be a pillar having substantially vertical sidewalls or a mesa having outwardly sloping sidewalls, for example formed by dry- and wet-etching respectively. The active and confinement regions 52, 51, 55 define a laser cavity with a total thickness which corresponds to $(2N+1)(\lambda/2n)$, where N is an integer.

The VCSEL 43 may operate as a laser. When a bias V is applied across the top and bottom contacts 45, 68, for example by applying a bias V to the top contact 68 using a source 69 while the bottom contact 45 is grounded, electromagnetic radiation 70, for example in the infra-red region of the spectrum, is emitted through a window from a top surface 71 of the waveguide structure 50. The window is substantially circular and preferably has a diameter d, between 10 and 15 $\mu$m. Electromagnetic radiation 72 may also be emitted through a window from a bottom surface 73 of the substrate 44. The window is substantially circular and preferably has a diameter $d_2$ of between 60 and 70 $\mu$m.

The VCSEL 43 described designed to be electrically pumped. The VCSEL 43 may be modified to be optically pumped. The modification includes using an undoped substrate 44 and undoped buffer, mirror, confinement and capping layers 46, 48, 49, 60, 61, 62, 63, 65, 66, 51, 55, 67 and omitting bottom and top contacts 45, 68.

The VCSEL 43 may operate as a modulator. First and second pulses 74, 75 may be fed into the top surface 71 and a third pulse 76 is output from the bottom surface 73.

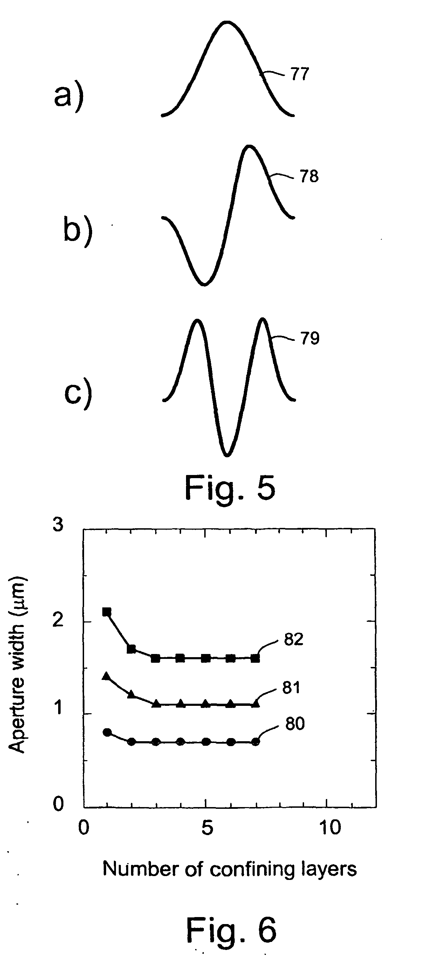

Referring to Figures 5a, 5b and 5c, first, second and third representations 77, 78, 79 of signal amplitude are shown corresponding to zero-, first- and second-order transverse modes.

Referring to Figures 6, 7 and 8, a problem associated with prior art VCSELs will be described.

Figure 6 shows first, second and third relationships 80, 81, 82 between aperture width for confining a transverse mode and number of $Al_xO_y$ confining layers for zero-, first- and second-order transverse modes 77, 78, 79 for a device having no first region. In other words, the device has no spacer. Such a device 21 having one confining layer is shown in Figure 2. A device having more than one confining layer may be made by modifying the device 21. To obtain zero-order transverse mode transmission, the aperture width is made about 0.7 $\mu$m.

Figure 6 also shows that as the number of confining layers increases, a narrower aperture is used for confinement.

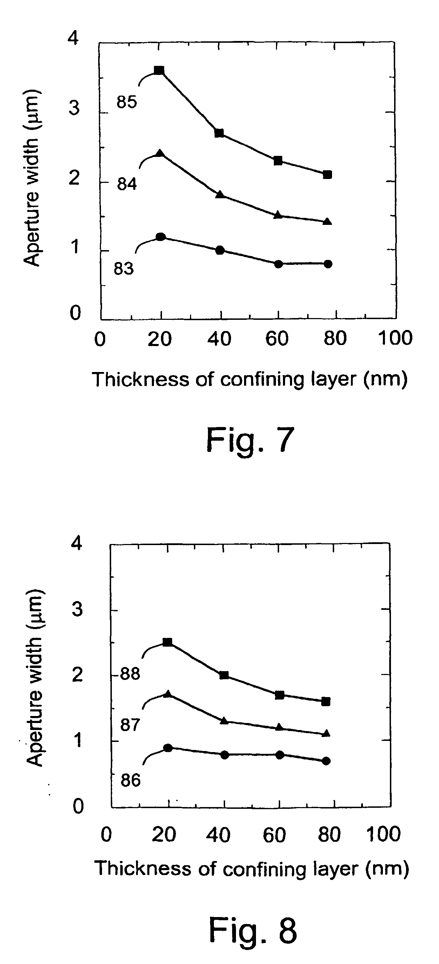

Figure 7 shows fourth, fifth and six relationships 83, 84, 85 between aperture width for confining a transverse mode and thickness of a single $Al_xO_y$ confining layer for zero-, first- and second-order transverse modes 77, 78, 79 for a device having no first region.

Figure 8 shows seventh, eighth and ninth relationships 86, 87, 88 between aperture width for confining a transverse mode and thickness of each of five $Al_xO_y$ confining layers for zero-, first- and second-order transverse modes 77, 78, 79 for a device having no first region.

Figures 6, 7 and 8 show that to obtain zero-order transverse mode transmission from the prior art VCSEL 21 or a modified device including additional confining layers, the size of the or each aperture is about 0.7 $\mu$m. Introducing thicker confining layers or increasing the number of confining layers serves to decrease the size of the aperture needed to produce a zero-order transverse mode.

Referring to Figures 3, 9 and 10, the VCSEL 43 according to the present invention has an advantage that the first region 57 allows a wider aperture to be used for zero-order transverse mode transmission.

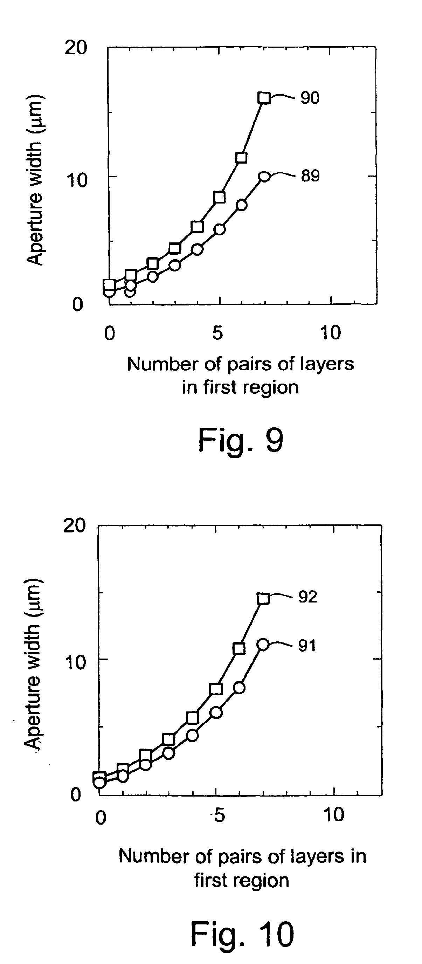

Figure 9 shows tenth and eleventh relationships 89, 90 between aperture width, W, for confining a transverse mode and number of pairs of mirror layers 60, 61 in the first region 57 for zero- and first-order transverse modes 77, 78 respectively, for a single confining layer 64.

Figure 10 shows twelfth and thirteenth relationships 91, 92 between aperture width, W, for confining a transverse mode and number of pairs of mirror layers 60, 61 in the first region 57 for zero- and first-order transverse modes 77, 78 respectively, for five confining layers 64.

Thus, increasing the number of layers 60, 61 with the first region 57 allows the aperture W to be made wider while still allowing zero-order transverse mode emission.

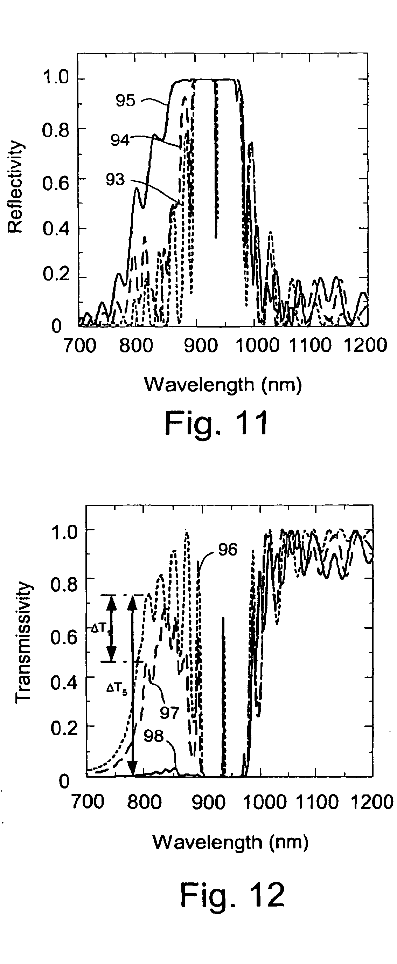

Referring to Figures 11 and 12, first, second and third calculated reflectance spectra 93, 94, 95 and first, second and third transmittance spectra 96, 97, 98 are shown for devices similar to the device 43 shown in Figure 3, emitting at 935 nm, having five pairs of mirror layers 60, 61 in the first region 57 and having zero, one and five $Al_xO_y$ confining layers 64 in the second region 58 respectively.

Using a greater number of $Al_xO_y$ confining layers 64 reduces transmissivity and increases reflectivity at shorter wavelengths. For example, in Figure 12, approximate differences in transmissivity between zero and one $Al_xO_y$ confining layers 64 and between zero and five $Al_xO_y$ confining layers 64 are marked $\Delta T_1$ and $\Delta T_5$ respectively, wherein $\Delta T_1 < \Delta T_5$.

As will be explained in more detail later, the disparity in transmissivity between regions not having $Al_xO_y$ confining layers 64 and regions having $Al_xO_y$ confining layers 64, referred to as a core and adjacent regions, is used in an optically pumped device to excite carriers in selective regions of the active region 52 (Figure 3) which helps to generate a stable fundamental mode.

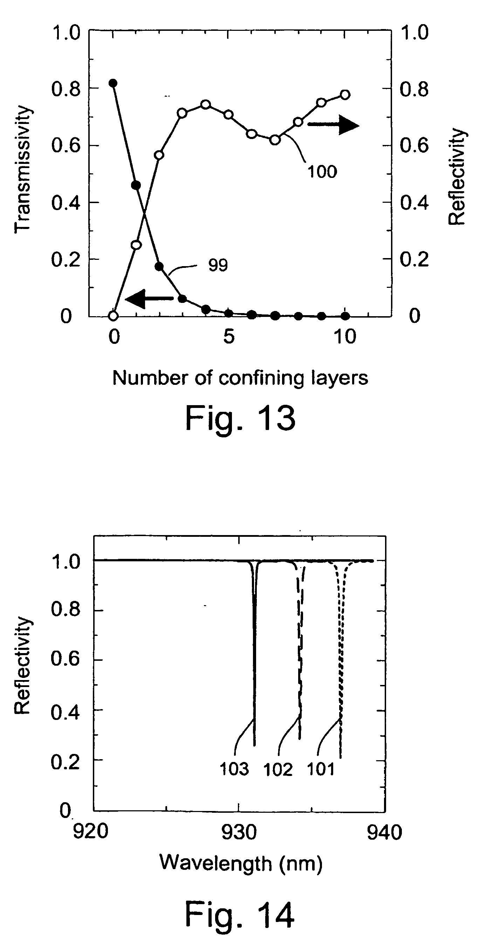

Referring to Figure 13, fourteenth and fifteenth relationships 99, 100 between calculated transmissivity and reflectivity at 935 nm respectively and number of confining layers 64 in the second region 58 are shown for devices similar to the device 43 shown in Figure 3 and having five mirror layers 60, 61 in the first region 57.

Referring to Figure 14, fourth, fifth and sixth reflectivity spectra 101, 102, 103 are shown for devices similar to the device 39 shown in Figure 3, having five pairs of mirror layers 60, 61 in the first region 57 and having zero, one and five $Al_xO_y$ confining layers 64 in the second region 58 respectively.

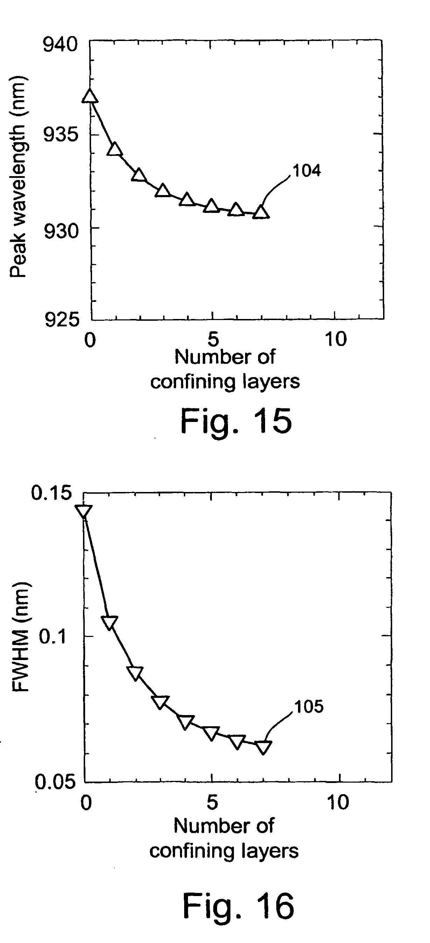

Referring to Figure 15, a sixteenth relationship 104 between resonant wavelength and number of confining layers 64 in the second region 58 is shown for devices similar to the device 43 shown in Figure 3 and having five mirror layers 60, 61 in the first region 57.

Referring to Figure 16, a seventeenth relationship 105 between full-width half-maximum (FWHM) and number of confining layers 64 in the second region 58 is shown for devices similar to the device 43 shown in Figure 3 and having five mirror layers 60, 61 in the first region 57.

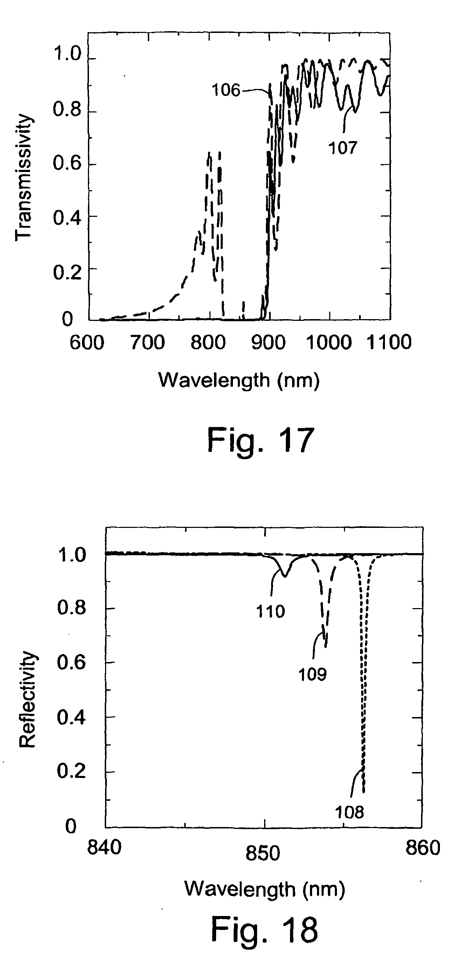

Referring to Figure 17, fourth and fifth calculated transmittance spectra 106, 107 are shown for devices similar to the device 43 shown in Figure 3, emitting at around 850 nm, having five pairs of mirror layers 60, 61 in the first region 57 and having zero and five $Al_xO_y$ confining layers 64 in the second region 58 respectively.

Referring to Figure 18, seventh, eighth and ninth reflectivity spectra 108, 109, 110 are shown for devices similar to the device 43 shown in Figure 3, emitting at around 856 nm, having five pairs of mirror layers 60, 61 in the first region 57 and having zero, one and five $Al_xO_y$ confining layers 64 in the second region 58 respectively. The resonance peak moves to a shorter wavelength as confining layers 59 are introduced.

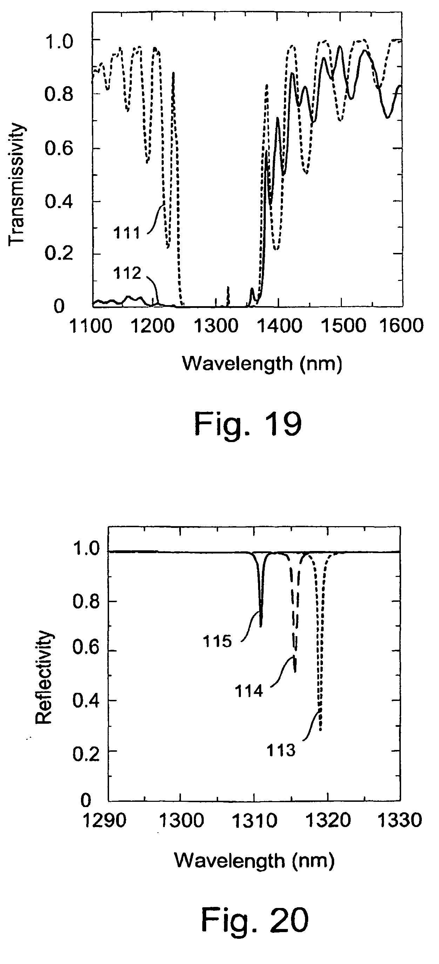

Referring to Figure 19, sixth and seventh calculated transmittance spectra 111, 112 are shown for devices similar to the device 43 shown in Figure 3, emitting at around 1300 nm, having five pairs of mirror layers 60, 61 in the first region 57 and having zero and five $Al_xO_y$ confining layers 64 in the second region 58 respectively. The alternating layers 53, 54 in the active region 52 are replaced with $Ga_{x1}In_{1-x1}As_{y1}P_{1-y1}$ and $Ga_{x2}In_{1-x2}As_{y2}P_{1-y2}$, wherein $x_1 > x_2$ and $y_1 > y_2$, or AlGaAs and GaInNAs respectively so as to shift resonance to a longer wavelength.

Referring to Figure 20, tenth, eleventh and twelfth reflectivity spectra 113, 114, 115 are shown for devices similar to the device 43 shown in Figure 3, emitting at around 1319 nm, having five pairs of mirror layers 60, 61 in the first region 57 and having zero, one and five $Al_xO_y$ confining layers 64 in the second region 58 respectively.

The resonance peak moves to a shorter wavelength as confining layers 64 are introduced.

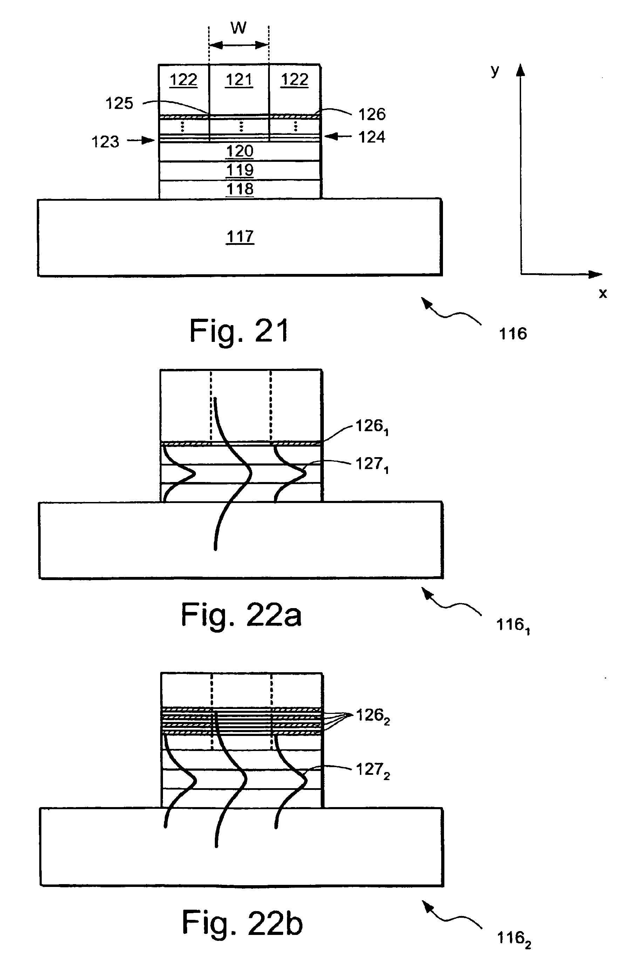

Referring to Figure 21, a generic VCSEL 116 is shown including a lower distributed Bragg reflector 117, a lower confinement region 118, an active region 119, an upper confinement region 120, an upper distributed Bragg reflector 121, 122. The upper distributed Bragg reflector 121, 122 may be divided into a core region 121 and adjacent region 122 traversing mirror layers 123, 124. The width of the core region 121 corresponds to the width of one or more apertures 125 defined using one or more confining layers 126.

For the generic VCSEL 116, an effective refractive index step, $\Delta n_{eff}$, may be calculated using:

$$\Delta n_{eff} = n_{core} - n_{adjacent} \qquad (2)$$

where

$$n_{core} = \int\limits_{-\infty}^{\infty} n(y)(E(y))^2 dy \qquad (3)$$

$$n_{adjacent} = \int\limits_{-\infty}^{\infty} n(y)(E(y))^2 dy \qquad (4)$$

where y is defined as the direction perpendicular to the mirror layers 123, 124.

$\Delta n_{eff}$ for VCSEL 43 is smaller than $\Delta n_{eff}$ for VCSEL 21. This is because VCSEL 43 distributes the optical field more widely in the adjacent region 122 than VCSEL 19.

Referring to Figures 22a and 22b, simplified VCSELS $116_1$, $116_2$ are shown corresponding to VCSEL 21 and VCSEL 43 respectively.

In the first VCSEL $116_1$ corresponding to the prior art VCSEL 21, a longitudinal optical field $127_1$ in an adjacent region $122_1$ is tightly confined and interacts strongly with a single confining layer $126_1$, thus giving rise to a low value of $n_{adjacent}$.

In the second VCSEL $116_2$, corresponding to the VCSEL 43 according to the present invention, a longitudinal optical field $127_2$ in an adjacent region $122_2$ is less tightly confined and interacts less strongly with confining layers $126_2$. This gives rise to a value of $n_{adjacent}$ which is closer to $n_{core}$.

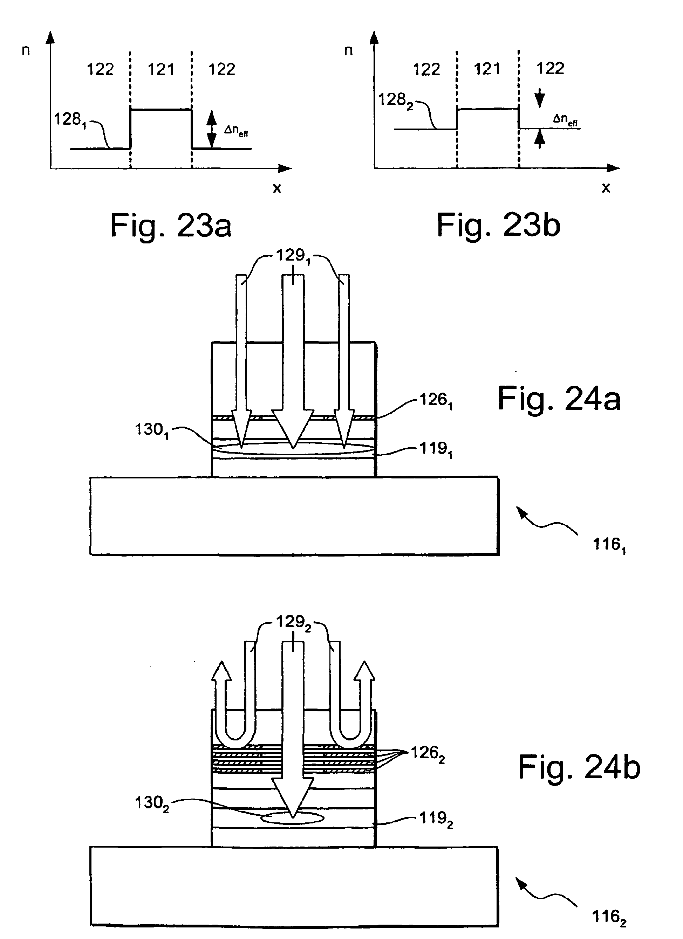

Referring to Figures 23a and 23b, first and second plots $128_1$, $128_2$ of effective refractive index $n_{eff}$ for the first and second VCSELs $116_1$, $116_2$ respectively are shown. For the first VCSEL $116_1$, a large difference in values between $n_{core}$ and $n_{adjacent}$ results in a large value of $\Delta n_{eff}$. For the second VCSEL $116_2$, a smaller difference in values between $n_{core}$ and $n_{adjacent}$ results in a smaller value of $\Delta n_{eff}$.

Thus, the second region 57 in VCSEL 43 (Figure 3) results in a smaller refractive index step, which helps to generate a stable fundamental mode.

As mentioned earlier, the disparity in transmissivity between regions not having $Al_xO_y$ confining layers 64 and regions having $Al_xO_y$ confining layers 64, i.e. the core and adjacent regions 121, 122, may also be used to help generate a stable fundamental mode.

Referring to Figures 24a and 24b, VCSELS $116_1$, $116_2$ are optically pumped by respective incident light pulses $129_1$, $129_2$.

In the first VCSEL $116_1$, corresponding to the prior art VCSEL 21, the difference in transmissivities $\Delta T$ between the core region 121, which has no $Al_xO_y$, and the adjacent regions 122, which have only one layer of $Al_xO_y$, is relatively small. Thus, a relatively large proportion an incident light pulse $129_1$ penetrates through the adjacent regions 122. This results in a relatively large region $130_1$ of the active region 119, being illuminated and carriers becoming excited. The wider lateral extent of excitation helps to promote generation of higher order transverse modes.

In the second VCSEL $116_1$, corresponding to the VCSEL 43 according to the present invention, the difference in transmissivities $\Delta T$ between the core region 121 and the adjacent regions 122, which in this case have five layers of $Al_xO_y$, is relatively large. A relatively small proportion an incident light pulse $129_2$ penetrates through the adjacent regions 122 due to a low value of transmissivity, as shown in Figure 12. This results in a relatively small region $130_2$ of the active region $119_2$ being illuminated and carriers being excited. Thus, a smaller region $119_2$ is excited which helps to promote generation of a fundamental transverse mode.

Thus, use of a plurality of confining layers 64 in the second region 57 in VCSEL 43 (Figure 3) helps to promote selective excitation.

A method of fabricating the VCSEL 43 for electrical pumping will now be described.

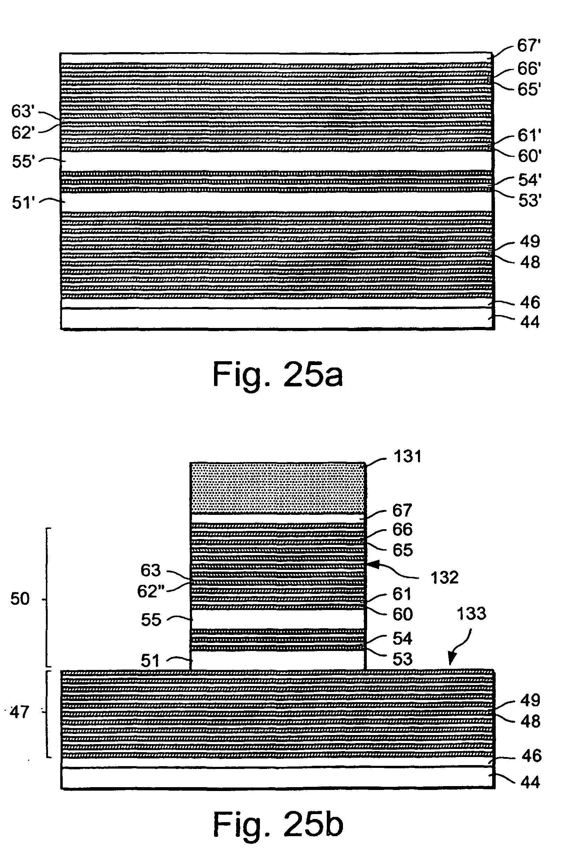

Referring to Figure 25a, (001)-orientated n-type GaAs is used as the substrate 44 and is loaded into a reactor (not shown) configured for molecular beam epitaxy (MBE). Alternatively, the reactor may be configured for metalorganic vapour phase epitaxy (MOVPE).

Twenty-five and half (25.5) pairs of alternating layers 48, 49 comprising $Al_{0.1}Ga_{0.9}As$ and AlAs are grown. Each $Al_{0.1}Ga_{0.9}As$ layer 48 is 67 nm thick and each AlAs layer 49 is 77 nm thick. The layers 48, 49 are doped with Si, to a concentration of at least $1\times10^{18}$ cm$^{-3}$.

An $Al_{0.4}Ga_{0.6}As$ layer 51' is then deposited having a thickness of 103 nm. The $Al_{0.4}Ga_{0.6}As$ layer 51' is doped with Si to a concentration of at least $8\times10^{17}$ cm$^{-3}$. Alternating layers 53', 54' comprising $Al_{0.1}Ga_{0.9}As$ and $In_{0.15}Ga_{0.85}As$ are grown. The $Al_{0.1}Ga_{0.9}As$ layers 53' are each 10 nm thick and the $In_{0.15}Ga_{0.85}As$ layers 54' are 7 nm thick. A layer 55' of $Al_{0.4}Ga_{0.6}As$ is then deposited having a thickness of 10 nm. The $Al_{0.4}Ga_{0.6}As$ layer 55' is doped with Be to a concentration of at least $8\times10^{17}$ cm$^{-3}$.

Five pairs of alternating layers 60', 61' comprising $Al_{0.9}Ga_{0.1}As$ and $Al_{0.1}Ga_{0.9}As$ are grown. Each $Al_{0.9}Ga_{0.1}As$ layer 60' is 76 nm thick and each $Al_{0.1}Ga_{0.9}As$ layer 61' is 67 nm thick. The layers 60', 61' are doped with Be to a concentration of at least $1 \times 10^{18}$ cm$^{-3}$. Five pairs of alternating layers 62', 63' comprising AlAs and $Al_{0.1}Ga_{0.9}As$ are grown. Each AlAs layer 62' is 77 nm thick and each $Al_{0.1}Ga_{0.9}As$ layer 62' is 67nm thick. The layers 62', 63' are doped with Be, to a concentration of at least $1 \times 10^{18}$ cm$^{-3}$. Fifteen and a half (15.5) pairs of alternating layers 65', 66' comprising $Al_{0.9}Ga_{0.1}As$ and $Al_{0.1}Ga_{0.9}As$ are grown. Each $Al_{0.9}Ga_{0.1}As$ layer 65' is 76 nm thick and each $Al_{0.1}Ga_{0.9}As$ layer 66' is 67 nm thick. The layers 65', 66' are doped with Be to a concentration of at least $1 \times 10^{18}$ cm$^{-3}$.

Finally, a capping layer 67' comprising GaAs is deposited. The capping layer 67' is 132 nm and is doped with Be to a concentration of at least $5 \times 10^{18}$ cm$^{-3}$.

Further buffer layers or superlattices may be inserted between layers. If the VCSEL 43 is to be optically pumped, then undoped layers may be used. Wafer bonding techniques may be used to construct layer structures.

The substrate 44 with epitaxial layers 46, 48, 49, 51', 53', 54', 55', 60', 61', 62', 63', 65' 66' is removed from the reactor (not shown) and processed.

Referring to Figure 25b, photo-resist (not shown) is applied to the surface of the capping layer 67' and patterned to form a mask 128. The mask 131 is circular and preferably has a diameter of between 25 to 35 $\mu$m.

Dry etching, in this case reaction ion etching (RIE) using silicon tetrachloride ($SiCl_4$) as a feed gas, is used to define the waveguide structure 50. Other dry etching processes may be used such as reactive ion beam etching (RIBE). Other feed gases may be used such as chlorine ($Cl_2$). In this example, the dry etch is configured so as to leave the waveguide structure 50 with substantially vertical sidewalls 132. The dry etch also leaves an upper surface 133 on the lower mirror 47. Wet etching may be used to define the waveguide structure 50, for example using sulphuric acid, water and hydrogen peroxide ($H_2SO_4/H_2O/H_2O_2$). Etching defines the lower confinement layer 51, the quantum well and barrier layers 53, 54, the upper confininement layer 55, $Al_{0.9}Ga_{0.1}As$ and $Al_{0.1}Ga_{0.9}As$ layers 60, 61, AlAs and $Al_{0.1}Ga_{0.9}As$ layers 62", 63 and the $Al_{0.9}Ga_{0.1}As$ and $Al_{0.1}Ga_{0.9}As$ layers 65, 66.

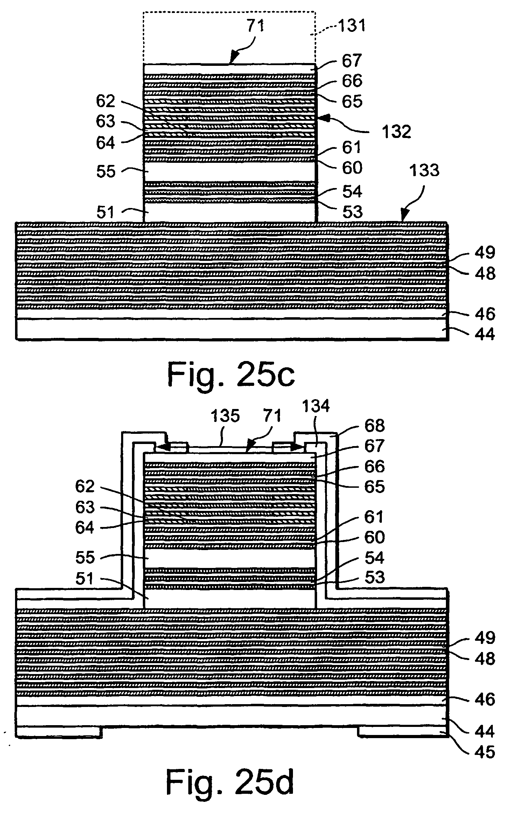

Referring to Figure 25c, the mask 131 is removed. Portions of the AlAs layers 62" (Figure 25b) adjacent to the sidewall 132 (Figure 23b) are oxidized using a hydrolyzation process described in Applied Physics Letters *ibid.* Thus, AlAs layers 62 are left with co-planar $Al_xO_y$ layers 64. Other methods of lateral diffusion may be used.

Referring to Figure 25d, photo-resist (not shown) is applied to the rear of the substrate 44 and patterned. AuGeNi and an optional gold capping layer is deposited by an evaporation process and lifted off to form the rear contact 45.

Silicon dioxide ($SiO_2$) 134 is sputtered so as to form a conformal layer over the waveguide 50, including the top surface 71 and the sidewall 132, and the upper surface 133 of the DBR. The thickness of the $SiO_2$ layer is 200 nm. Other dielectrics such as silicon nitride ($Si_3N_4$) may be used. Photo-resist (not shown) is applied over the $SiO_2$ and patterned to open a window (not shown) and dry etching, in this case reaction ion etching (RIE) using carbon tetrafluoride ($CF_4$) as a feed gas, is used to define the window 135 in the $SiO_2$ conformal layer 134.

Photo-resist (not shown) is applied over the $SiO_2$ conformal layer 134 and patterned to form a circular mask (not shown). Sequential layers of titanium, platinum and gold (TiPtAu) are deposited by an evaporation process and lifted off to the form the top contact 68.

The rear and front contacts 45, 68 are annealed using a rapid thermal annealing process.

Further processing steps may be performed, such as definition of bond pads.

The fabrication process hereinbefore described takes advantage of preferential oxidation of AlAs over $Al_{0.9}Ga_{0.1}As$ (and also over $Al_{0.1}Ga_{0.9}As$). Thus, the upper distributed Bragg reflector 56 (Figure 3) includes AlAs and $Al_{0.9}Ga_{0.1}As$ as low refractive index material.

However, the fabrication process may be modified so as to enable a single low refractive index material, such as AlAs, to be included in the upper distributed Bragg reflector 56 (Figure 3).

The fabrication process may be modified by depositing AlAs layers instead of $Al_{0.9}Ga_{0.1}As$ layers 60', 65' (Figure 25a), dividing dry etching process into three stages, introducing a protective layer after a first dry etching stage and performing hydrolyzation after a second dry etching stage, as will now be described in more detail:

Beginning with a modified layer structure, the waveguide structure 50 is partially formed by etching to a point corresponding to the bottom of the third region 59 (Figure 3). The etch may be chosen to leave a residue on the sidewall which is impermeable to the oxidizing agent. Alternatively, a protective layer, such as silicon nitride, may be deposited, for example using an isotropic deposition which covers both horizontal and vertical surfaces and a subsequent isotropic etch which removes the protective layer from horizontal surfaces thereby leaving the protective layer on the vertical surfaces, such as sidewalls.

The waveguide structure 50 is further partially formed by further etching to point corresponding to the bottom of the second region 58 (Figure 3). Portions of AlAs layers adjacent to the sidewall within the second region 58 are oxidized using the hydrolyzation process referred to earlier. However, portions of AlAs layers adjacent to the sidewall within the third region 58 are not oxidized since they are protected by the protective layer.

The waveguide structure 50 is completed by etching to a point corresponding to the bottom of the lower confining layer 51 (Figure 3). The protective layer may be removed.

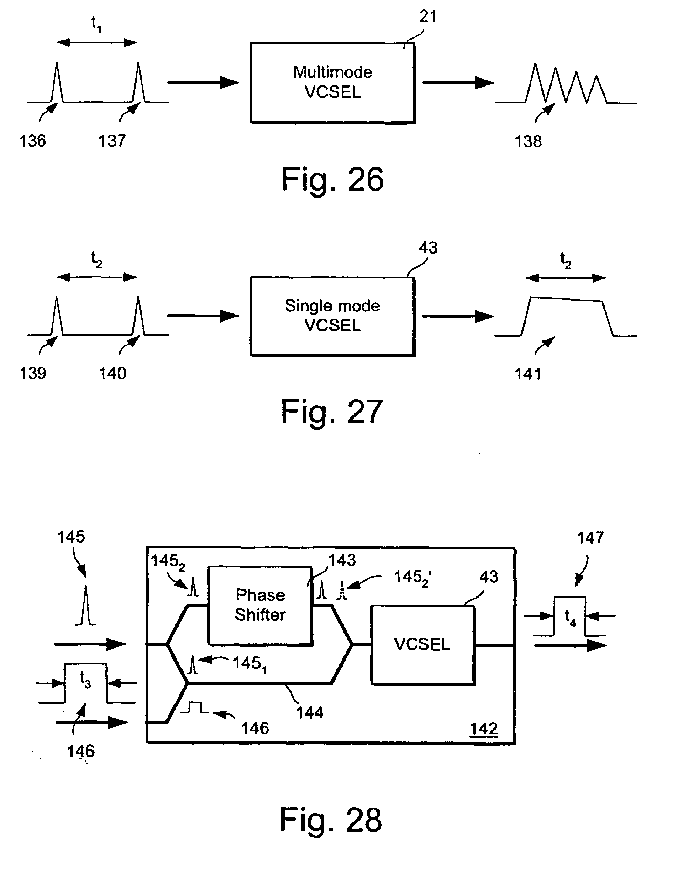

Referring to Figure 26, a drawback of using the VCSEL 21 as an optical modulator is that multimode beating occurs. A pair of pulses 136, 137 spaced by a period $t_1$ are fed into the VCSEL 21. The pulses 136, 137 each have a duration of about 1fs to 1 ps. The first pulse 136 generates excited carriers which relax and emit photons so producing an output signal 138. The output exhibits beating. The second pulse 137 is used for phase control so as to remove excited carriers using destructive interference. However, this process is complicated by beating due to the multimode coupling and redistribution of optical fields. Mode beating is disadvantageous for the fast optical response of optical signals and the control of pulse shape by phase control. It is also disadvantageous for the optical switching. Therefore, it is desirable to suppress multimode operation of a VCSEL to achieve the fast and simple optical response with a longer coherence time.

Referring to Figure 27, the VCSEL 43 according to the present invention may be configured as a singlemode optical modulator. A pair of pulses 139, 140 spaced by a period $t_2$ are fed into the VCSEL 43. The pulses 139, 140 each have a duration of about 1 fs to 1 ps. The first pulse 139 generates excited carriers which relax and emit photons so producing an output signal 141. The second pulse 140 is used for phase control so as to remove excited using destructive interference.

For a description of techniques used in coherent control, reference is made to "Ultrafast Coherent Control and Destruction of Excitons in Quantum Wells" by A. P. Heberle *et al.,* Physical Review Letters, volume 75, pp. 2598-2601 (1995) and "Coherent Control of Exciton Density and Spin" by A. P. Heberle et al., IEEE Journal of Selected Topics in Quantum Electronics, volume 2, pp. 769-774 (1996).

Referring to Figure 28, an integrated optical device 142 comprise a single mode VSCEL 43, a phase shifter 143 and waveguides 144. The device 142 is configured to receive an input pulse 145 of duration $t_3$ and a controlling mode-locking pulse signal 146. The controlling pulse 146 is split into two controlling signals $146_1$, $146_2$. The phase shifter 143 delays the second controlling pulse $146_2$ relative to the first controlling signal $146_1$ by a period $t_4$ to produce a delayed pulse $146_2$'. The first and second controlling pulses $146_1$, $146_2$ are used to switch VCSEL 43 on and off to produce an output signal 147 with a pulse width of $t_4$, wherein $t_3 > t_4$. The output signal 147 may also be amplified relative to the input signal 145.

Thus, the integrated device 142 may be used to modulate a long input pulse fed into the VCSEL 43 and operate as an optically-controlled modulator. The input pulse 145 can also be used to excite the carriers in the single mode VCSEL 43 by optical pumping.

Further phase shifters may be used to construct more complex devices. Other devices may be integrated into the device such as Mach-Zendher type interferometers and detectors.

It will be appreciated that many modifications may be made to the embodiment hereinbefore described.

For example, other materials may be used in the distributed Bragg reflector instead of GaAs, AlAs and AlGaAs. The materials may dielectrics having relatively high and relatively low refractive index. The materials may be semiconductors, such as GaInAsP/InP or AlGaAs/GaInNAs material system for 1.3 $\mu$m emission or GaInAsP/InP material system for 1.55 $\mu$m emission. Other materials may be used as a confining layer instead of $Al_xO_y$. For example, other oxides such as magnesium oxide (MgO), nitrides or halides may be used.

The materials may also vary throughout the distributed Bragg reflector or regions of the distributed Bragg reflector from one layer to another of the same "type", i.e. a layer of high or low refractive index, such as layer 62. In other words, the same material need not be used in every layer 62. Different materials may be used in layers 62, 63, 64 to produce the same differences in refractive index, i.e. $\Delta n_{\text{layer 62/layer 64}}$ = constant and $\Delta n_{\text{layer 62/layer 63}}$ = constant. Different materials may also be used which need not keep the difference in refractive index the same, but maintain a relatively large difference between layers 62, 64 and relatively small difference between layers 63, 64, i.e. $\Delta n_{\text{layer 62/layer 64}} > \Delta n_{\text{layer 62/layer 63}}$. Thus, distributed Bragg reflectors may be used in which material composition varies smoothly or rapidly, significantly or slightly.

**Claims**

**1.** An optical device (43) including:

a lower mirror layer (47) comprising a first distributed Bragg reflector comprising a plurality of alternating layers (48, 49) of relatively high and relatively low refractive index material, and
a columnar waveguide structure (50) upstanding from the lower mirror layer, the structure comprising:

a lower confinement layer (51) formed on said lower mirror (47),
an active region (52) formed on said lower confinement layer (51) and which comprises one or more quantum wells arranged to emit electromagnetic radiation at a given wavelength $\lambda$,

an upper confinement layer (55) formed on said active region (52) and

**characterised by** an upper mirror (56) formed on said upper confinement layer (55) and which comprises a second distributed Bragg reflector comprising a plurality of alternating layers (60, 61, 62, 63, 65, 66) of relatively high and relatively low refractive index material and which further comprises between three and seven annular confining layers (64),

wherein said upper mirror (56) comprises first, second and third regions (57, 58, 59),

said first region (57) formed on said upper confinement layer (55) and which comprises said plurality of alternating layers (60, 61) of relatively high and relatively low refractive index material,

said second region (58) formed on said first region (57) and which comprises said plurality of alternating layers (62, 63) of relatively high and relatively low refractive index material, and which comprises said annular confining layers (64), said confining layers (64) arranged to be co-planar with said layers (62) of one material in said plurality of alternating layers (62, 63), such that each of said confining layer (64) forms a respective aperture in said corresponding layer (62) having a diameter of between 1 and 6 $\mu$m, said aperture being filled with said material and said confining layers (64) having a refractive index lower than said layers (62, 63) and said confining layers having a thickness t substantially equal to the thickness of the corresponding layer, the thickness t being substantially equal to $\lambda/4n$, where n is a value of refractive index of the material in the corresponding layer, and said third region (59) formed on said second regions (58) and which comprises said plurality of alternating layers (65, 66) of relatively high and relatively low refractive index material;

wherein said confining layers are for stabilizing and guiding a fundamental transverse mode wave through a core region (121) of said mirror.

2. A device according to claim 1, wherein said second region (58) comprises five confining layers.

3. A device according to claim 1 or 2, wherein said confining layers (64) comprise aluminium oxide.

4. A device according to any preceding claim, wherein said first region (57) comprises between two and eight pairs of layers (60, 61) comprising relatively high and relatively low refractive index material.

5. A device according to any preceding claim, wherein said first region (57) comprises between three and seven pairs of layers (60, 61) comprising relatively high and relatively low refractive index material.

6. A device according to any preceding claim, wherein said first region (57) comprises alternating layers of $Al_{0.9}Ga_{0.1}As$ and $Al_{0.1}Ga_{0.9}As$.

7. A device according to any preceding claim, wherein said second region (58) comprises alternating layers of AlAs and $Al_{0.1}Ga_{0.9}As$.

8. A device according to any preceding claim, wherein confining means (64) is configured to limit transverse modes of electromagnetic radiation propagating through said mirror (56).

9. A device according to any preceding claim, wherein confining region (64) is configured to allow propagation of a fundamental transverse mode through said mirror (56).

10. A device according to any preceding claim, which is a vertical-cavity surface-emitting laser (VCSEL).

11. A device according to any preceding claim configured to be electrically pumped.

12. A device according to any preceding claim configured to be optically pumped.

13. A device according to any preceding claim wherein said upper and lower mirrors (56, 47) are arranged to form a cavity.

14. A device according to claim 13, wherein said cavity has a length of an order of a wavelength of the electromagnetic radiation.

15. A device according to any preceding claim, wherein said upper mirror (56) is disposed relatively close to a surface for emitting or receiving electromagnetic radiation and said lower mirror (47) is disposed relatively far from said surface.

16. A device according to any preceding claim, wherein said mirror (56) is disposed relatively far from a substrate and said other mirror (47) is disposed relatively close to said substrate.

17. Apparatus (142) including:

means (144) for splitting a first pulse into second and third pulses;
means (143) for delaying said third pulse by a known period so as to produce a delayed third pulse;
a device (43) according to any preceding claim;
means (144) for feeding a fourth pulse into said device; and
means (144) for feeding said first and delayed third pulses into said device.

18. A method of fabricating an optical device (43) comprising:

providing a lower mirror layer (47) comprising a first distributed Bragg reflector comprising a plurality of alternating layers (48, 49) of relatively high and relatively low refractive index material, and
providing a columnar waveguide structure (50) upstanding from the lower mirror layer, the structure comprising:

a lower confinement layer (51) formed on said lower mirror (47),
an active region (52) formed on said lower confinement layer (51) and which comprises one or more quantum wells arranged to emit electromagnetic radiation at a given wavelength $\lambda$,

providing an upper confinement layer (55) on said active region (52) and
providing an upper mirror (56) formed on said upper confinement layer (55) and which comprises a second distributed Bragg reflector comprising a plurality of alternating layers (60, 61, 62, 63, 65, 66) of relatively high and relatively low refractive index material and between three and seven annular confining layers (64),
**characterised by** providing said upper mirror (56) comprising:

providing first, second and third regions (57, 58, 59),
said first region (57) formed on said upper confinement layer (55) and which comprises said plurality of alternating layers (60, 61) of relatively high and relatively low refractive index material,
said second region (58) formed on said first region (57) and which comprises said plurality of alternating layers (62, 63) of relatively high and relatively low refractive index material, and which further comprises between three and seven annular confining layers (64) arranged to be co-planar with said layers (62) of one material in said plurality of said alternating layers (62, 63), such that each of said confining layers (64) forms a respective aperture in said corresponding layer (62) having a diameter of between 1 and 6 $\mu$m, said aperture being filled with said material and said confining layers (64) having a refractive index lower than said layers (62, 63), and said confining layers having a thickness t substantially equal to the thickness of the corresponding layer, the thickness t being substantially equal to $\lambda/4n$, where n is a value of refractive index of the material in the corresponding layer, and
said third region (59) formed on said second regions (58) and which comprises said plurality of alternating layers (65, 66) of relatively high and relatively low refractive index material,

wherein said confining layers are for stabilizing and guiding a fundamental transverse mode wave through a core region (121) of said mirror.

**Patentansprüche**

1. Optische Vorrichtung (43), die umfasst:

eine untere Spiegelschicht (47), die einen ersten verteilten Bragg-Reflektor enthält, der mehrere abwechselnde Schichten (48, 49) aus einem Material mit verhältnismäßig hohem bzw. verhältnismäßig niedrigem Brechungsindex aufweist, und
eine säulenartige Wellenleiterstruktur (50), die von der unteren Spiegelschicht nach oben steht und umfasst:

eine untere Einschlussschicht (51), die auf dem unteren Spiegel (47) ausgebildet ist, einen aktiven Bereich (52), der auf der unteren Einschlussschicht (51) ausgebildet ist und einen oder mehrere Quantentöpfe aufweist, die so beschaffen sind, dass sie elektromagnetische Strahlung mit einer gegebenen Wellenlänge λ aussenden, und

eine obere Einschlussschicht (55), die auf dem aktiven Bereich (52) ausgebildet ist,

**gekennzeichnet durch**

einen oberen Spiegel (56), der auf der oberen Einschlussschicht (55) ausgebildet ist und einen zweiten verteilten Bragg-Reflektor enthält, der mehrere abwechselnde Schichten (60, 61, 62, 63, 65, 66) aus einem Material mit verhältnismäßig hohem bzw. verhältnismäßig niedrigem Brechungsindex aufweist und ferner zwischen drei und sieben ringförmige Einschlussschichten (64) enthält,

wobei der obere Spiegel (56) einen ersten, einen zweiten und einen dritten Bereich (57, 58, 59) umfasst,

der erste Bereich (57) auf der oberen Einschlussschicht (55) ausgebildet ist und die mehreren abwechselnden Schichten (60, 61) aus einem Material mit verhältnismäßig hohem bzw. verhältnismäßig niedrigem Brechungsindex aufweist,

der zweite Bereich (58) auf dem ersten Bereich (57) ausgebildet ist und die mehreren abwechselnden Schichten (62, 63) aus einem Material mit verhältnismäßig hohem bzw. verhältnismäßig niedrigem Brechungsindex aufweist und die ringförmigen Einschlussschichten (64) enthält, wobei die Einschlussschichten (64) so beschaffen sind, dass sie zu den Schichten (62) eines der Materialien in den mehreren abwechselnden Schichten (62, 63) koplanar sind, derart, dass jede der Einschlussschichten (64) in der entsprechenden Schicht (62) eine jeweilige Öffnung mit einem Durchmesser im Bereich von 1 bis 6 μm bildet, die mit dem Material gefüllt ist, wobei die Einschlussschichten (64) einen Brechungsindex besitzen, der niedriger als jener der Schichten (62, 63) ist und wobei die Einschlussschichten eine Dicke t besitzen, die im Wesentlichen gleich der Dicke der entsprechenden Schicht ist, wobei die Dicke t im Wesentlichen gleich λ/4n ist, wobei n ein Wert des Brechungsindexes des Materials in der entsprechenden Schicht ist, und

der dritte Bereich (59) auf dem zweiten Bereich (58) ausgebildet ist und die mehreren abwechselnden Schichten (65, 66) aus einem Material mit verhältnismäßig hohem bzw. verhältnismäßig niedrigem Brechungsindex aufweist;

wobei die Einschlussschichten der Stabilisierung und Führung einer transversalen Grundmodenwelle **durch** einen Kernbereich (121) des Spiegels dienen.

2. Vorrichtung nach Anspruch 1, bei der der zweite Bereich (58) fünf Einschlussschichten umfasst.

3. Vorrichtung nach Anspruch 1 oder 2, bei der die Einschlussschichten (64) Aluminiumoxid enthalten.

4. Vorrichtung nach einem der vorhergehenden Ansprüche, bei der der erste Bereich (57) zwischen zwei und acht Paare von Schichten (60, 61) enthält, die ein Material mit verhältnismäßig hohem bzw. verhältnismäßig niedrigem Brechungsindex enthalten.

5. Vorrichtung nach einem vorhergehenden Anspruch, bei der der erste Bereich (57) zwischen drei und sieben Paare von Schichten (60, 61) enthält, die ein Material mit verhältnismäßig hohem bzw. verhältnismäßig niedrigem Brechungsindex enthalten.

6. Vorrichtung nach einem vorhergehenden Anspruch, bei der der erste Bereich (57) abwechselnd Schichten aus $Al_{0,9}Ga_{0,1}As$ bzw. aus $Al_{0,1}Ga_{0,9}As$ enthält.

7. Vorrichtung nach einem vorhergehenden Anspruch, bei der der zweite Bereich (58) abwechselnd Schichten aus AlAs bzw. $Al_{0,1}Ga_{0,9}As$ enthält.

8. Vorrichtung nach einem vorhergehenden Anspruch, bei der die Einschlusseinrichtung (64) so konfiguriert ist, dass sie transversale Moden von elektromagnetischer Strahlung, die sich durch den Spiegel (56) ausbreitet, begrenzt.

9. Vorrichtung nach einem vorhergehenden Anspruch, bei der der Einschlussbereich (64) so konfiguriert ist, dass er die Ausbreitung einer transversalen Grundmode durch den Spiegel (56) zulässt.

10. Vorrichtung nach einem vorhergehenden Anspruch, die ein Oberflächenemissions-Laser mit vertikalem Hohlraum (VCSEL) ist.

11. Vorrichtung nach einem vorhergehenden Anspruch, die so konfiguriert ist, dass sie elektrisch gepumpt wird.

12. Vorrichtung nach einem vorhergehenden Anspruch, die so konfiguriert ist, dass sie optisch gepumpt wird.

**13.** Vorrichtung nach einem vorhergehenden Anspruch, bei der der obere Spiegel und der untere Spiegel (56, 47) so angeordnet sind, dass sie einen Hohlraum bilden.

**14.** Vorrichtung nach Anspruch 13, bei der der Hohlraum eine Länge in der Größenordnung einer Wellenlänge der elektromagnetischen Strahlung hat.

**15.** Vorrichtung nach einem vorhergehenden Anspruch, bei der der obere Spiegel (56) relativ nahe bei einer Oberfläche zum Emittieren oder Empfangen elektromagnetischer Strahlung angeordnet ist und der untere Spiegel (47) relativ weit weg von dieser Oberfläche angeordnet ist.

**16.** Vorrichtung nach einem vorhergehenden Anspruch, bei der der Spiegel (56) relativ weit weg von einem Substrat angeordnet ist und der andere Spiegel (47) relativ nahe bei dem Substrat angeordnet ist.

**17.** Gerät (142), das umfasst:

eine Einrichtung (144), die einen ersten Impuls in einen zweiten und einen dritten Impuls aufteilt;
eine Einrichtung (143), die den dritten Impuls um eine bekannte Zeitdauer verzögert, um einen verzögerten dritten Impuls zu erzeugen;
eine Vorrichtung (43) nach einem vorhergehenden Anspruch;
eine Einrichtung (144) zum Liefern eines vierten Impulses in die Vorrichtung; und
eine Einrichtung (144) zum Liefern des ersten und des verzögerten dritten Impulses in die Vorrichtung.

**18.** Verfahren zum Herstellen einer optischen Vorrichtung (43), das umfasst:

Vorsehen einer unteren Spiegelschicht (47), die einen ersten verteilten Bragg-Reflektor enthält, der mehrere abwechselnde Schichten (48, 49) aus einem Material mit verhältnismäßig hohem bzw. verhältnismäßig niedrigem Brechungsindex aufweist, und
Vorsehen einer säulenartigen Wellenleiterstruktur (50), die von der unteren Spiegelschicht nach oben steht und umfasst:

eine untere Einschlussschicht (51), die auf dem unteren Spiegel (47) ausgebildet ist, einen aktiven Bereich (52), der auf der unteren Einschlussschicht (51) ausgebildet ist und einen oder mehrere Quantentöpfe enthält, die so beschaffen sind, dass sie elektromagnetische Strahlung mit einer gegebenen Wellenlänge λ aussenden,

Vorsehen einer oberen Einschlussschicht (55) auf dem aktiven Bereich (52) und
Vorsehen eines oberen Spiegels (56), der auf der oberen Einschlussschicht (55) ausgebildet ist und einen zweiten verteilten Bragg-Reflektor enthält, der mehrere abwechselnde Schichten (60, 61, 62, 63, 65, 66) aus einem Material mit verhältnismäßig hohem bzw. verhältnismäßig niedrigem Brechungsindex sowie zwischen drei und sieben ringförmige Einschlussschichten (64) aufweist,
**dadurch gekennzeichnet, dass** das Vorsehen des oberen Spiegels (56) das Vorsehen eines ersten, eines zweiten und eines dritten Bereichs (57, 58, 59) umfasst,

wobei der erste Bereich (57) auf der oberen Einschlussschicht (55) ausgebildet wird und die mehreren abwechselnden Schichten (60, 61) aus einem Material mit verhältnismäßig hohem bzw. verhältnismäßig niedrigem Brechungsindex aufweist,
der zweite Bereich (58) auf dem ersten Bereich (57) ausgebildet ist und die mehreren abwechselnden Schichten (62, 63) aus einem Material mit verhältnismäßig hohem bzw. verhältnismäßig niedrigem Brechungsindex aufweist und ferner zwischen drei und sieben ringförmige Einschlussschichten (64) aufweist, die so angeordnet sind, dass sie zu den Schichten (62) aus einem der Materialien in den mehreren abwechselnden Schichten (62, 63) koplanar sind, derart, dass jede der Einschlussschichten (64) eine entsprechende Öffnung in der entsprechenden Schicht (62) bildet, deren Durchmesser im Bereich von 1 bis 6 μm liegt, wobei die Öffnung mit dem Material gefüllt ist und wobei die Einschlussschichten (64) einen niedrigeren Brechungsindex besitzen als die Schichten (62, 63) und wobei die Einschlussschichten eine Dicke t besitzen, die im Wesentlichen gleich der Dicke der entsprechenden Schicht ist, wobei die Dicke t im Wesentlichen gleich λ/4n ist, wobei n ein Wert eines Brechungsindexes des Materials in der entsprechenden Schicht ist, und
der dritte Bereich (59) auf dem zweiten Bereichen (58) ausgebildet ist und die mehreren abwechselnden Schichten (65, 66) aus einem Material mit verhältnismäßig hohem bzw. verhältnismäßig niedrigem Brechungsindex aufweist,

wobei die Einschlussschichten der Stabilisierung und Führung einer transversalen Grundmodenwelle durch einen Kernbereich (121) des Spiegels dienen.

## Revendications

1. Dispositif optique (43), comportant :

une couche de miroir inférieure (47) comprenant un premier réflecteur de Bragg réparti comprenant une pluralité de couches alternées (48, 49) de matériaux d'indice de réfraction relativement élevé et relativement faible, et une structure de guide d'ondes en colonne (50) s'élevant depuis la couche de miroir inférieure, la structure comprenant :

une couche de confinement inférieure (51) formée sur ledit miroir inférieur (47),
une région active (52) formée sur ladite couche de confinement inférieure (51) et qui comprend un ou plusieurs puits quantiques disposés de façon à émettre un rayonnement électromagnétique à une longueur d'onde $\lambda$ donnée,
une couche de confinement supérieure (55) formée sur ladite région active (52) et
**caractérisé par** un miroir supérieur (56) formé sur laite couche de confinement supérieure (55) et qui comprend un second réflecteur de Bragg réparti comprenant une pluralité de couches alternées (60, 61, 62, 63, 65, 66) de matériaux d'indice de réfraction relativement élevé et relativement faible et qui comprend en outre de trois à sept couches de confinement annulaires (64),
dans lequel ledit miroir supérieur (56) comprend des première, seconde et troisième régions (57, 58, 59), ladite première région (57) étant formée sur ladite couche de confinement supérieure (55) et comprenant ladite pluralité de couches alternées (60, 61) de matériaux d'indice de réfraction relativement élevé et relativement faible,
ladite seconde région (58) étant formée sur ladite première région (57) et comprenant ladite pluralité de couches alternées (62, 63) de matériaux d'indice de réfraction relativement élevé et relativement faible, et comprenant lesdites couches de confinement annulaires (64), lesdites couches de confinement (64) étant disposées de façon à être coplanaires avec lesdites couches (62) d'un matériau de ladite pluralité de couches alternées (62, 63), de façon que chacune desdites couches de confinement (64) forme une ouverture respective dans ladite couche correspondante (62), ayant un diamètre compris entre 1 et 6 $\mu$m, ladite ouverture étant remplie dudit matériau et lesdites couches de confinement (64) ayant un indice de réfraction inférieur à celui desdites couches (62, 63) et lesdites couches de confinement ayant une épaisseur t sensiblement égale à l'épaisseur de la couche correspondante, l'épaisseur t étant sensiblement égale à $\lambda/4n$, où n est une valeur de l'indice de réfraction du matériau de la couche correspondante, et
ladite troisième région (59) étant formée sur lesdites secondes régions (58) et comprenant ladite pluralité de couches alternées (65, 66) de matériaux d'indice de réfraction relativement élevé et relativement faible ;
dans lequel lesdites couches de confinement servent à stabiliser et à guider une onde de mode transverse fondamental à travers la région de coeur (121) dudit miroir.

2. Dispositif selon la revendication 1, dans lequel ladite seconde région (58) comprend cinq couches de confinement.

3. Dispositif selon la revendication 1 ou 2, dans lequel lesdites couches de confinement (64) comprennent de l'oxyde d'aluminium.

4. Dispositif selon l'une quelconque des revendications précédentes, dans lequel ladite première région (57) comprend de deux à huit paires de couches (60, 61) comprenant des matériaux d'indice de réfraction relativement élevé et relativement faible.

5. Dispositif selon l'une quelconque des revendications précédentes, dans lequel ladite première région (57) comprend de trois à sept paires de couches (60, 61) comprenant des matériaux d'indice de réfraction relativement élevé et relativement faible.

6. Dispositif selon l'une quelconque des revendications précédentes, dans lequel ladite première région (57) comprend des couches alternées d'$Al_{0,9}Ga_{0,1}As$ et d'$Al_{0,1}Ga_{0,9}As$.

7. Dispositif selon l'une quelconque des revendications précédentes, dans lequel ladite seconde région (58) comprend des couches alternées d'AlAs et d'$Al_{0,1}Ga_{0,9}As$.

8. Dispositif selon l'une quelconque des revendications précédentes, dans lequel le moyen de confinement (64) est configuré de façon à limiter les modes transverses du rayonnement électromagnétique se propageant à travers ledit miroir (56).

9. Dispositif selon l'une quelconque des revendications précédentes, dans lequel la région de confinement (64) est configurée pour permettre la propagation d'un mode transverse fondamental à travers ledit miroir (56).

10. Dispositif selon l'une quelconque des revendications précédentes, qui est un laser à émission de surface à cavité verticale (VCSEL pour "Vertical Cavity Surface Emitting Laser").

11. Dispositif selon l'une quelconque des revendications précédentes, configuré de façon à être pompé électriquement.

12. Dispositif selon l'une quelconque des revendications précédentes, configuré de façon à être pompé optiquement.

13. Dispositif selon l'une quelconque des revendications précédentes, dans lequel lesdits miroirs supérieur et inférieur (56, 47) sont disposés de façon à former une cavité.

14. Dispositif selon la revendication 13, dans lequel ladite cavité a une longueur de l'ordre d'une longueur d'onde du rayonnement électromagnétique.

15. Dispositif selon l'une quelconque des revendications précédentes, dans lequel ledit miroir supérieur (56) est disposé relativement près d'une surface servant à émettre ou à recevoir un rayonnement électromagnétique et ledit miroir inférieur (47) est disposé relativement loin de ladite surface.

16. Dispositif selon l'une quelconque des revendications précédentes, dans lequel ledit miroir (56) est disposé relativement loin d'un substrat et ledit autre miroir (47) est disposé relativement près dudit substrat.

17. Appareil (142), comportant :

    un moyen (144) pour séparer une première impulsion en des seconde et troisième impulsions ;
    un moyen (143) pour retarder ladite troisième impulsion d'une période connue de façon à produire une troisième impulsion retardée ;
    un dispositif (43) selon l'une quelconque des revendications précédentes ;
    un moyen (144) pour appliquer une quatrième impulsion audit dispositif ; et
    un moyen (144) pour appliquer ladite première impulsion et ladite troisième impulsion retardée audit dispositif.

18. Procédé de fabrication d'un dispositif optique (43), consistant à :

    prévoir une couche de miroir inférieure (47) comprenant un premier réflecteur de Bragg réparti comprenant une pluralité de couches alternées (48, 49) de matériaux d'indice de réfraction relativement élevé et relativement faible, et
    prévoir une structure de guide d'ondes en colonne (50) s'élevant depuis la couche de miroir inférieure, la structure comprenant :

        une couche de confinement inférieure (51) formée sur ledit miroir inférieur (47),
        une région active (52) formée sur ladite couche de confinement inférieure (51) et comprenant un ou plusieurs puits quantiques conçus pour émettre un rayonnement électromagnétique à une longueur d'onde λ donnée,
        prévoir une couche de confinement supérieure (55) sur ladite région active (52) et
        prévoir un miroir supérieur (56) formé sur ladite couche de confinement supérieure (55) et comprenant un second réflecteur de Bragg réparti comprenant une pluralité de couches alternées (60, 61, 62, 63, 65, 66) de matériaux d'indice de réfraction relativement élevé et relativement faible et de trois à sept couches de confinement annulaires (64),
        **caractérisé par** la prévision dudit miroir supérieur (56) comprenant :

            le fait de prévoir des première, seconde et troisième régions (57, 58, 59),

ladite première région (57) étant formée sur ladite couche de confinement supérieure (55) et comprenant ladite pluralité de couches alternées (60, 61) de matériaux d'indice de réfraction relativement élevé et relativement faible,

ladite seconde région (58) étant formée sur ladite première région (57) et comprenant ladite pluralité de couches alternées (62, 63) de matériaux d'indice de réfraction relativement élevé et relativement faible, et comprenant en outre de trois à sept couches de confinement annulaires (64) disposées de façon à être coplanaires avec lesdites couches (62) d'un matériau de ladite pluralité desdites couches alternées (62, 63), de façon que chacune des couches de confinement (64) forme une ouverture respective dans ladite couche correspondante (62), ayant un diamètre de 1 à 6 $\mu$m, ladite ouverture étant remplie dudit matériau et lesdites couches de confinement (64) ayant un indice de réfraction inférieur à celui desdites couches (62, 63) et lesdites couches de confinement ayant une épaisseur t sensiblement égale à l'épaisseur de la couche correspondante, l'épaisseur t étant sensiblement égale à $\lambda/4n$, où n est une valeur de l'indice de réfraction du matériau de la couche correspondante, et

ladite troisième région (59) étant formée sur lesdites secondes régions (58) et comprenant ladite pluralité de couches alternées (65, 66) de matériaux d'indice de réfraction relativement élevé et relativement faible ;

dans lequel lesdites couches de confinement servent à stabiliser et à guider une onde de mode transverse fondamental à travers la région de coeur (121) dudit miroir.

Fig. 1 (Prior art)

Fig. 2 (Prior art)

Fig. 3

Fig. 4

a)

~77

b)

~78

c)

~79

## Fig. 5

## Fig. 6

Fig. 7

Fig. 8

Number of pairs of layers
in first region

Fig. 9

Number of pairs of layers in
first region

Fig. 10

Fig. 11

Fig. 12

Fig. 13

Fig. 14

Fig. 15

Fig. 16

Fig. 17

Fig. 18

Fig. 19

Fig. 20

W

| 122 | 121 | 122 |

125

126

123 →

← 124

120
119
118

117

y

x

**Fig. 21**

116

126₁

127₁

**Fig. 22a**

116₁

126₂

127₂

**Fig. 22b**

116₂

Fig. 23a

Fig. 23b

Fig. 24a

Fig. 24b

Fig. 25a

Fig. 25b

71 ---131

67
66
65

62
63
64

132

61
60

55

54
53

51

133

49
48

46
44

## Fig. 25c

135   71   134

68
67
66
65

62
63
64

61
60

55
51

54
53

49
48

46
44
45

## Fig. 25d

Fig. 26

Fig. 27

Fig. 28